# EUROPEAN PATENT APPLICATION

(11) **EP 0 584 403 A1**
(43) Date of publication of application: **02.03.1994**
(21) Application number: 92121191.8
(22) Date of filing: 11.12.1992
(51) Int. Cl.: H03K 17/693, G01R 19/165

(54) **Circuit calculating the minimum value**

(30) Priority: 26.08.1992 JP 252093/92
(71) Applicant: YOZAN INC., Tokyo 155 (JP); SHARP KABUSHIKI KAISHA, Osaka 545 (JP)
(72) Inventor: Shu, Goliang, Setagaya-ku, Tokyo 155 (JP); Yang, Weikang, Setagaya-ku, Tokyo 155 (JP); Wongwarawipat, Wiwat, Setagaya-ku, Tokyo 155 (JP); Takatori, Sunao, Setagaya-ku, Tokyo 155 (JP); Yamamoto, Makoto, Setagaya-ku, Tokyo 155 (JP)
(74) Representative: Grünecker, Kinkeldey, Stockmair & Schwanhäusser Anwaltssozietät

(57) **Abstract**

A circuit calculating the minimum value comprising a plural number of pMOS (T1,T2,...), wherein the sources of the plural pMOS (T1,T2,...) are connected to a power source (-Vcc) with lower voltage than a drain, the drain is grounded through a high resistance (R), an input voltage (X,Y,...) is connected to each pMOS (T1,T2,...), and a common output (Do) is connected to a drain of each pMOS (T1,T2,...).

## Description

### -FIELD OF THE INVENTION-

The present invention relates to a circuit calculating the minimum value for outputting the minimum value of a plural number of inputs.

### -BACKGROUND OF THE INVENTION-

Conventionally, a complicated operation, such as the calculation of the minimal value in a plural number of data, has been often realized by a digital computer, and it has been necessary a rather large structure using plural steps of comparison circuits and multiplexer.

### -SUMMARY OF THE INVENTION-

The present invention is invented so as to solve the above problem and has an object to provide a circuit of small size calculating the minimal value in high speed.

The circuit calculating the minimal value according to the present invention uses switching of the characteristic of a plural number of pMOS. Breaking is on pMOS except the one received the minimal input by connecting the drain of pMOS to the common output, inputting input voltage to the gate of each pMOS, making the pMOS received the minimal input conductive and generating voltage in the drain side by the conduction.

### BRIEF DESCRIPTION OF THE DRAWINGS

T1, T2 and T3 are pMOS.

D1, D2 and D3 are source follower outputs.

x, y and z are input voltage.

Do is the common output.

R is a high speed resistance.

-Vcc is a power source.

### -PREFERRED DISCRIPTION OF THE EMBODIMENT-

Hereinafter an embodiment of the circuit calculating the minimum value is described with reference to the attached drawings.

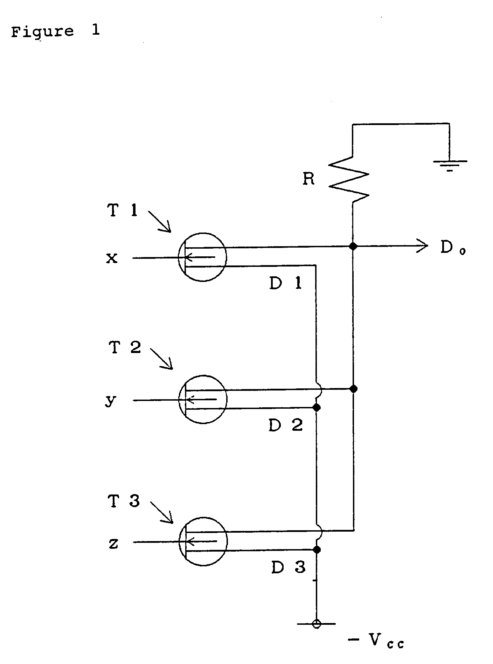

In Figure 1, the circuit calculating the minimal value connects a plural number of pMOS ("T1", "T2" and "T3") in parallel. Input voltage "x", "y" and z" are input to T1, T2 and T3, respectively. T1, T2 and T3 comprises outputs source follower outputs D1, D2 and D3, respectively. These outputs are connected to the common output Do.

The independent characteristic of each pMOS is: the output equivalent to the input voltage is generated in the drain as D1=x, D2=y and D3=z.

When the condition is x< y and x< z, T1 has the output D1 as x. T2 and T3 have drain voltage lower than gate voltage. Therefore, T2 and T3 receive breaking and D1 is the Do as it is. When y or z is the minimal value, the same processing is performed and the minimal input is the Do.

The above embodiment connects three pMOS in parallel. It is possible to output the minimal input voltage between two or within 4 or more by connecting pMOS by 2 pieces, 4 pieces or more, similarly.

The necessary time for obtaining these outputs is almost equal to the corresponding time of one pMOS. This is exceedingly higher speed than the case of operation of digital circuit. The size of the circuit is very small, as is clear from the structure.

As mentioned, the circuit calculating the minimum value is small size and high speed corresponding because the minimal value of each pMOS is generated in the common output by connecting the source follower output of pMOS to the common output.

## Claims

1. A circuit calculating the minimum value comprising a plural number of pMOS, wherein source of said plural pMOS are connected to a power source with lower voltage than a drain, said drain is grounded through high resistance, in input voltage is connected to each pMOS, and a common output is connected to a drain of each pMOS.
